# EUROPEAN PATENT SPECIFICATION

(11) **EP 4 033 551 B1**
(45) Date of publication and mention of the grant of the patent: **22.05.2024**
(21) Application number: 20865413.7
(22) Date of filing: 25.06.2020
(51) Int. Cl.: H01F 6/06, H01B 12/06, H10N 60/355

(54) **PERMANENT CURRENT SWITCH AND SUPERCONDUCTING DEVICE**
DAUERSTROMSCHALTER UND SUPRALEITENDE VORRICHTUNG
COMMUTATEUR À COURANT PERMANENT ET DISPOSITIF SUPRACONDUCTEUR

(30) Priority: 20.09.2019 JP 2019171570
(43) Date of publication of application: 27.07.2022
(73) Proprietor: SUMITOMO ELECTRIC INDUSTRIES, LTD., Osaka-shi, Osaka 541-0041 (JP)
(72) Inventor: YAMAGUCHI, Takashi, Osaka-shi, Osaka 541-0041 (JP); OHKI, Kotaro, Osaka-shi, Osaka 541-0041 (JP); NAGAISHI, Tatsuoki, Osaka-shi, Osaka 541-0041 (JP)
(74) Representative: Grünecker Patent- und Rechtsanwälte PartG mbB
(86) International application number: PCT/JP2020/025063
(87) International publication number: WO 2021/053921

(56) References cited:
- JP-A- 2003 069 093
- JP-A- 2003 069 093
- JP-A- 2014 216 412
- JP-A- 2018 117 042
- JP-A- 2018 117 042
- JP-A- 2019 096 849
- JP-A- 2019 160 817

## Description

### TECHNICAL FIELD

The present invention relates to a persistent current switch and a superconducting device. The present application claims priority based on Japanese Patent Application No. 2019-171570 filed on September 20, 2019.

### BACKGROUND ART

Japanese Patent Laying-Open No. 2018-117042 (PTL 1) discloses a persistent current switch. The persistent current switch includes a superconducting wire and a heater wire. The superconducting wire and the heater wire form a co-wound coil.

### CITATION LIST

### PATENT LITERATURE

PTL 1: Japanese Patent Laying-Open No. 2018-117042,
JP2003069093 A discloses a high-temperature superconductor being formed in the shape of predetermined a pattern on a base material and consisting of an insulator and a heater and patent document JP201909684 illustrates a permanent current switch including a non-induction coil in which a superconducting tape and a heater tape are spirally wound.

### SUMMARY OF INVENTION

A persistent current switch of the present disclosure includes a superconducting wire, a heater, and an insulating member according to the independent device claim 1.

A superconducting device of the present disclosure includes the persistent current switch of the present disclosure, a superconducting coil connected to the persistent current switch, and a container that accommodates the persistent current switch and the superconducting coil.

### BRIEF DESCRIPTION OF DRAWINGS

Fig. 1 is a schematic view illustrating a superconducting device according to a first embodiment to a fourth embodiment.
Fig. 2 is a schematic partially enlarged view illustrating the persistent current switch of the first embodiment.
Fig. 3 is a schematic sectional view illustrating the persistent current switch of the first embodiment taken along a sectional line III-III in Fig. 2.
Fig. 4 is a schematic partially enlarged view illustrating a persistent current switch according to a first modification of the first embodiment.
Fig. 5 is a schematic partially enlarged view illustrating a persistent current switch according to a second modification of the first embodiment.
Fig. 6 is a schematic partially enlarged view illustrating a persistent current switch according to a third modification of the first embodiment.
Fig. 7 is a schematic cross-sectional view illustrating a process of preparing a superconducting member.
Fig. 8 is a schematic sectional view illustrating a process of dividing the superconducting member.
Fig. 9 is a circuit diagram of a superconducting device illustrating an operation of the persistent current switch of the first embodiment.
Fig. 10 is a circuit diagram of the superconducting device illustrating the operation of the persistent current switch of the first embodiment.
Fig. 11 is a circuit diagram of the superconducting device illustrating the operation of the persistent current switch of the first embodiment.
Fig. 12 is a circuit diagram of the superconducting device illustrating the operation of the persistent current switch of the first embodiment.
Fig. 13 is a circuit diagram of the superconducting device illustrating the operation of the persistent current switch of the first embodiment.
Fig. 14 is a circuit diagram of the superconducting device illustrating the operation of the persistent current switch of the first embodiment.
Fig. 15 is a graph illustrating a relationship between power consumption of a heater and off-resistance of the persistent current switch in the persistent current switch of the first embodiment and the persistent current switch of a comparative example.
Fig. 16 is a schematic sectional view illustrating a persistent current switch according to a second embodiment.
Fig. 17 is a schematic plan view illustrating a persistent current switch according to a third embodiment.
Fig. 18 is a schematic sectional view illustrating the persistent current switch of the third embodiment taken along a sectional line XVIII-XVIII in Fig. 17.
Fig. 19 is a schematic sectional view illustrating the persistent current switch of the third embodiment taken along a sectional line XIX-XIX in Fig. 17.
Fig. 20 is a schematic sectional view illustrating the persistent current switch of the third embodiment taken along a sectional line XX-XX illustrated in Fig. 17.
Fig. 21 is a schematic sectional view illustrating a persistent current switch according to a fourth embodiment.
Fig. 22 is a schematic sectional view illustrating a persistent current switch according to a first modification of the fourth embodiment.

### DETAILED DESCRIPTION

### [Problem to be Solved by the Present Disclosure]

Persistent current switches are required to operate with lower power consumption. An object of the present invention according to the independent device claim 1 is to provide a persistent current switch and a superconducting device that operate with lower power consumption.

### [Advantageous Effect of the Present Disclosure]

According to the present disclosure, a persistent current switch and a superconducting device that operate with lower power consumption can be provided.

### Description of Examples

First, examples will be listed and described.
(1) A persistent current switch of the present disclosure includes a superconducting wire, a heater, and an insulating member. The superconducting wire includes a substrate and a superconducting layer provided on the substrate. The superconducting layer includes a first principal surface facing the substrate and a second principal surface on an opposite side of the first principal surface. The heater is disposed only on the second principal surface side with respect to the superconducting layer. The insulating member is provided between the second principal surface of the superconducting layer and the heater. In the present disclosure, the fact that the superconducting layer is formed on the substrate means that the superconducting layer is directly formed on the substrate or that the superconducting layer is formed on an intermediate layer formed on the substrate.
   In the persistent current switch of (1), the heater is disposed only on the second principal surface side with respect to the superconducting layer. The heat dissipated to the substrate in the heat generated by the heater is reduced. The superconducting layer can be efficiently heated by a heater. In addition, because the insulating member is provided between the second principal surface of the superconducting layer and the heater, the insulating member prevents current flowing through the heater from flowing into the superconducting layer. Accordingly, the power consumption of the heater necessary for operating the persistent current switch is reduced. The persistent current switch of (1) can operate with lower power consumption.
(2) In the persistent current switch of (1), the superconducting wire further includes a protective layer having conductivity. The protective layer is provided on the second principal surface of the superconducting layer and is in contact with the superconducting layer. The insulating member is provided between the protective layer and the heater.
   When quenching (a phenomenon of transition from a superconducting state to a normal conducting state) occurs in the superconducting layer, the protective layer bypasses the current flowing through the superconducting layer. In the persistent current switch of (2), burnout of the superconducting wire can be prevented. In addition, the insulating member prevents the current flowing through the heater from flowing into the superconducting layer and the protective layer. The power consumption of the heater required to operate the persistent current switch is reduced. The persistent current switch of (2) can operate with lower power consumption.
(3) In the persistent current switch of (2), the protective layer and the superconducting layer are separated from the substrate.
   Accordingly, the heat generated by the heater is prevented from being dissipated to the substrate. The power consumption of the heater required to operate the persistent current switch is reduced. The persistent current switch of (3) can operate with lower power consumption.
(4) In the persistent current switch of (1), the superconducting wire further includes the protective layer having the conductivity. The protective layer is provided on the second principal surface of the superconducting layer and is in contact with the superconducting layer. The superconducting layer includes a first portion, a second portion, and a third portion between the first portion and the second portion along a longitudinal direction of the superconducting wire. The protective layer is provided only on the first portion and the second portion. The heater is provided only on the third portion and is separated from the protective layer. The insulating member is provided between the heater and the third portion.

Because the protective layer is provided only on the first portion and the second portion, the current flowing through the superconducting wire cannot bypass the third portion. When the third portion of the superconducting layer is heated by the heater to be in the normal conducting state, all the current flowing through the superconducting wire flows through the third portion having high electric resistance. For this reason, even when a heating length or heating area of the superconducting layer using the heater is smaller, a high off-resistance of the persistent current switch can be obtained. The power consumption of the heater required to operate the persistent current switch is reduced. The persistent current switch can operate with less power consumption.

In addition, the heater is provided only on the third portion of the superconducting layer and is separated from the protective layer. Accordingly, the current flowing through the heater is prevented from flowing into the protective layer. The power consumption of the heater required to operate the persistent current switch is reduced. The persistent current switch can operate with less power consumption.

(5) In the persistent current switch in any one of (2) to (4), the superconducting wire further includes a stabilization layer having conductivity. The stabilization layer is in contact with the protective layer. The protective layer is provided between the superconducting layer and the stabilization layer. The heater is spaced apart from the stabilization layer.

When the quenching (the phenomenon of transition from the superconducting state to the normal conducting state) occurs in the superconducting layer, the stabilization layer bypasses the current flowing through the superconducting layer. In the persistent current switch of (5), the burnout of the superconducting wire can be prevented. In addition, the heater is separated from the stabilization layer. Accordingly, the current flowing through the heater is prevented from flowing into the protective layer and the stabilization layer. The power consumption of the heater required to operate the persistent current switch is reduced. The persistent current switch can operate with less power consumption.

(6) In the persistent current switch of any one of (1) to (5), the superconducting wire includes an intermediate layer having an insulating property. The intermediate layer is provided between the substrate and the first principal surface.

The intermediate layer prevents the current flowing through the heater from flowing into the substrate. The power consumption of the heater required to operate the persistent current switch is reduced. The persistent current switch of (6) can operate with lower power consumption.

(7) In the persistent current switch of any one of (2) to (5), the superconducting wire includes the intermediate layer having the insulating property. The intermediate layer is provided between the substrate and the first principal surface. In plan view of the second principal surface of the superconducting layer, a first side edge of the protective layer is located inside a second side edge of the intermediate layer.

Accordingly, heat dissipation from the heater to the substrate through the protective layer can be reduced. The power consumption of the heater required to operate the persistent current switch is reduced. The persistent current switch of (5) can operate with lower power consumption.

(8) In the persistent current switch of (7), a third side edge of the superconducting layer is located inside the second side edge of the intermediate layer in plan view of the second principal surface of the superconducting layer.

Accordingly, the heat dissipation from the heater to the substrate through the superconducting layer can be reduced. The power consumption of the heater required to operate the persistent current switch is reduced. The persistent current switch of (8) can operate with lower power consumption.

(9) In the persistent current switch of any one of (1) to (8), the superconducting wire has a non-coil shape. In the present disclosure, the fact that the superconducting wire has the non-coil shape means that the superconducting wire does not have a coil shape. The superconducting wire having the coil shape means that the superconducting wire at least partly overlaps in a radial direction of the curved portion of the superconducting wire.

In the persistent current switch of (9), magnitude of a magnetic field generated from the persistent current switch can be reduced. A restriction on an installation position of the persistent current switch can be reduced.

(10) The persistent current switch of any one of (1) to (9) further includes a holding member. A held portion of the superconducting wire is held by the holding member. The heater is provided only on a part of the held portion of the superconducting wire.

For this reason, the length of the heater is shortened. The power consumption of the heater required to operate the persistent current switch is reduced. The persistent current switch of (10) can operate with lower power consumption.

(11) In the persistent current switch of (8), the heater is provided over a length less than or equal to 50% of a length of the held portion of the superconducting wire in the longitudinal direction of the superconducting wire.

For this reason, the length of the heater is shortened. The power consumption of the heater required to operate the persistent current switch is reduced. The persistent current switch of (11) can operate with lower power consumption.

(12) In the persistent current switch of any one of (1) to (11), the superconducting layer is made of RE₁Ba₂Cu₃O_{y}. y is greater than or equal to 6.0 and less than or equal to 8.0, and RE represents a rare earth element.

In general, an oxide superconducting material such as RE₁Ba₂Cu₃O_{y} has a higher superconducting transition temperature than a metal superconducting material such as NbTi. Accordingly, a cooling structure and operation control of the persistent current switch can be simplified. In addition, a superconducting wire including a superconducting layer formed of the oxide superconducting material such as RE₁Ba₂Cu₃O_{y} has high critical current density even in a high magnetic field. Accordingly, the persistent current switch can be placed at a position where the high magnetic field is applied. A restriction on an installation position of the persistent current switch can be reduced.

(13) The superconducting device of the present disclosure includes the persistent current switch of any one of (1) to (12), a superconducting coil connected to the persistent current switch, and a container that accommodates the persistent current switch and the superconducting coil.

Accordingly, the superconducting device of the present disclosure can operate with lower power consumption.
[Detailed Embodiments of the Present Disclosure] With reference to the drawings, details of embodiments will be described below. In the drawings, the same or corresponding parts are denoted by the same reference numerals, and the description will not be repeated. At least some configurations of the embodiments described below may be arbitrarily combined.

### (First Embodiment)

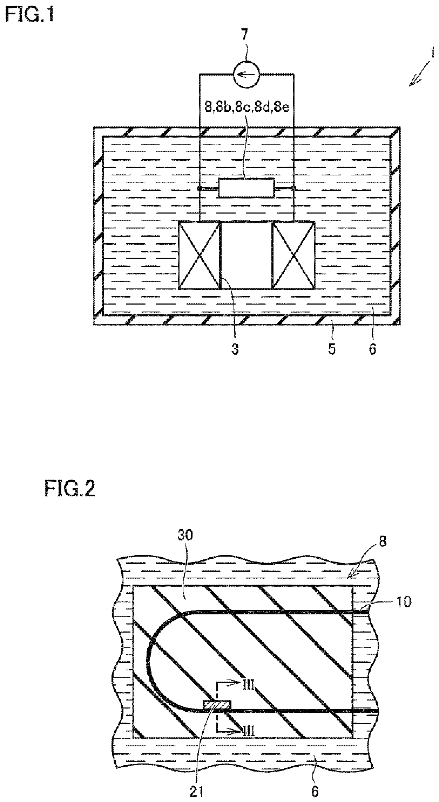

With reference to Fig. 1, a superconducting device 1 according to a first embodiment will be described. For example, superconducting device 1 is a superconducting magnet, a nuclear magnetic resonance (NMR) device, and a magnetic resonance imaging (MRI) device. Superconducting device 1 includes a superconducting coil 3, a container 5, and a persistent current switch 8. Superconducting coil 3 generates a magnetic field used for measurement by the superconducting device 1. Superconducting coil 3 is connected in parallel to the persistent current switch 8. Container 5 accommodates persistent current switch 8 and superconducting coil 3. Container 5 is a heat insulating container such as a cryostat. Container 5 contains a liquid refrigerant 6 such as liquid helium. Liquid refrigerant 6 cools superconducting coil 3 and persistent current switch 8.

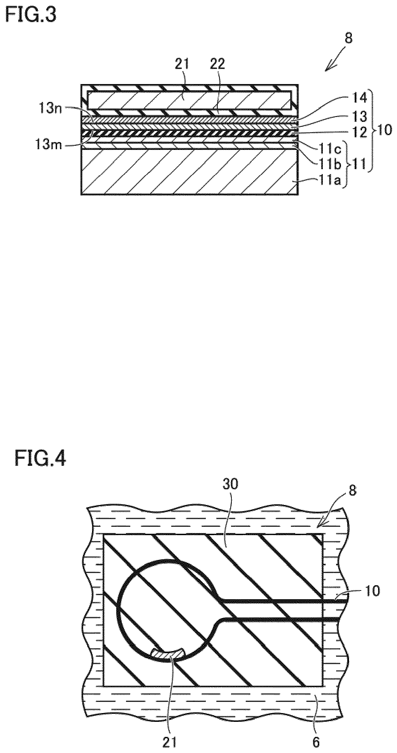

With reference to Figs. 2 and 3, persistent current switch 8 of the first embodiment will be described. Persistent current switch 8 includes a superconducting wire 10, a heater 21, an insulating member 22, and a holding member 30. The superconducting wire 10 includes a substrate 11, an intermediate layer 12, a superconducting layer 13, and a protective layer 14.

Substrate 11 includes a first layer 11a, a second layer 11b, and a third layer 11c. Second layer 11b is provided between first layer 11a and third layer 11c. Substrate 11 has conductivity. For example, first layer 11a is made of stainless steel or hastelloy (registered trademark). For example, second layer 11b is made of copper (Cu) or a copper alloy. Third layer 11c is made of nickel (Ni). In the first embodiment, substrate 11 is a three-layer substrate. However, substrate 11 may be a single-layer substrate or a double-layer substrate.

Intermediate layer 12 is formed on substrate 11 (third layer 11c). Intermediate layer 12 is provided between substrate 11 and a first principal surface 13m of superconducting layer 13. Intermediate layer 12 separates superconducting layer 13 and protective layer 14 from substrate 11. For example, intermediate layer 12 is a crystal orientation layer. Intermediate layer 12 has an insulating property. Intermediate layer 12 electrically insulates protective layer 14 and superconducting layer 13 from substrate 11. Intermediate layer 12 is not particularly limited, but is made of, for example, stabilized zirconia (YSZ), yttrium oxide (Y₂O₃), or cerium oxide (CeO₂).

Superconducting layer 13 is provided on substrate 11. In the present specification, the fact that superconducting layer 13 is provided on substrate 11 means that superconducting layer 13 is directly formed on substrate 11 or that superconducting layer 13 is formed on intermediate layer 12 formed on substrate 11. Superconducting layer 13 includes first principal surface 13m facing substrate 11 and a second principal surface 13n on the opposite side of first principal surface 13m. For example, superconducting layer 13 is made of an oxide superconductor. For example, superconducting layer 13 is RE₁Ba₂Cu₃O_{y}. y is greater than or equal to 6.0 and less than or equal to 8.0. RE represents a rare earth element, and is, for example, at least one element selected from the group consisting of yttrium (Y), praseodymium (Pr), neodymium (Nd), samarium (Sm), eurobium (Eu), gadolium (Gd), holmium (Ho), or ytterbium (Yb).

Protective layer 14 is provided on second principal surface 13n of superconducting layer 13. Protective layer 14 is in contact with superconducting layer 13. Protective layer 14 is separated from substrate 11. Protective layer 14 has conductivity. For example, protective layer 14 is formed of a metal such as silver (Ag) or an alloy. When the quenching (the phenomenon of transition from the superconducting state to the normal conducting state) occurs in superconducting layer 13, protective layer 14 bypasses the current flowing through superconducting layer 13 to prevent the burning of the superconducting wire.

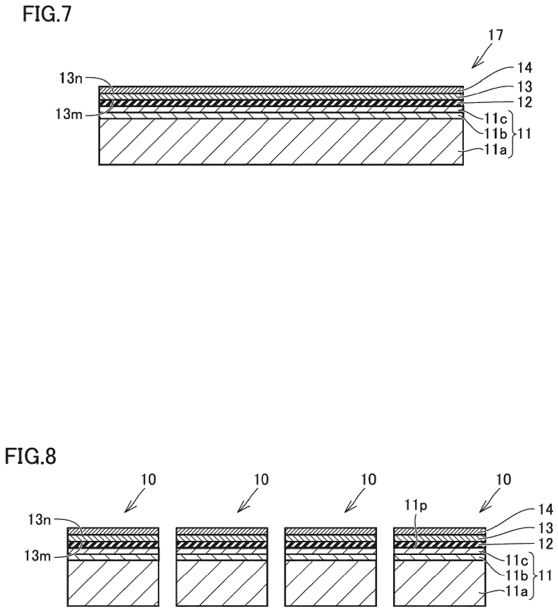

With reference to Figs. 7 and 8, an example of a method for manufacturing superconducting wire 10 will be described. The method for manufacturing superconducting wire 10 includes a process of preparing superconducting member 17 (see Fig. 7) and a process of dividing superconducting member 17 (see Fig. 8).

As illustrated in Fig. 7, in the process of preparing superconducting member 17, superconducting member 17 is formed. Superconducting member 17 has a laminated structure similar to that of superconducting wire 10, and the width of superconducting member 17 is at least twice larger than that of superconducting wire 10. Specifically, intermediate layer 12 is formed on substrate 11. Intermediate layer 12 is formed by an ion beam assisted deposition method (IBAD method) or the like. Then, superconducting layer 13 is formed on intermediate layer 12 by a metal-organic compound decomposition method (MOD method) or the like. Subsequently, protective layer 14 is formed on superconducting layer 13 by a vapor deposition method or the like. In this way, superconducting member 17 is formed.

As illustrated in Fig. 8, in the process of dividing superconducting member 17, superconducting member 17 is divided into a plurality of superconducting wires 10 in the width direction of superconducting member 17. For example, superconducting member 17 is divided by machining (machine slit) or laser machining (laser slit). In this way, superconducting wire 10 is obtained.

As illustrated in Fig. 3, heater 21 is disposed only on the side of second principal surface 13n of superconducting layer 13 with respect to superconducting layer 13. Heater 21 is not disposed on the side of first principal surface 13m of superconducting layer 13 with respect to superconducting layer 13. For example, heater 21 is an electric heating layer, an electric heating sheet, or a meandering electric heating wire. For example, the electric heating layer, the electric heating sheet, or the electric heating wire is made of nichrome.

Insulating member 22 has an insulating property. As illustrated in Fig. 3, insulating member 22 is provided between second principal surface 13n of superconducting layer 13 and heater 21. Insulating member 22 prevents the current flowing through heater 21 from flowing into superconducting layer 13. Specifically, insulating member 22 is provided between protective layer 14 and heater 21. Insulating member 22 prevents the current flowing through heater 21 from flowing into superconducting layer 13 and protective layer 14. Specifically, insulating member 22 covers an entire circumference of a section of heater 21 perpendicular to the longitudinal direction of superconducting wire 10. For example, insulating member 22 is an insulating adhesive or an insulating adhesive tape, and heater 21 is attached to superconducting wire 10.

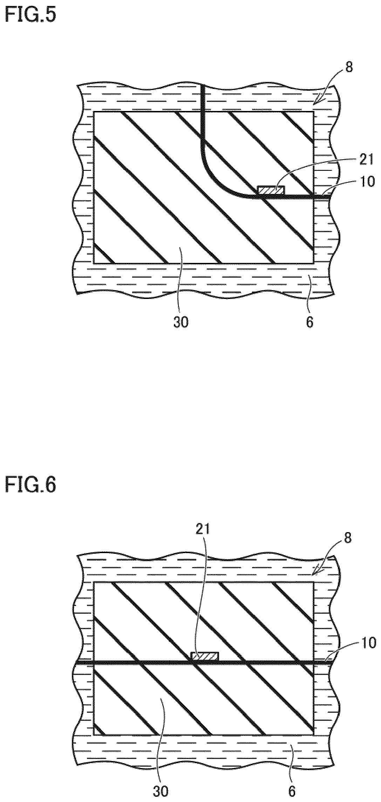

As illustrated in Fig. 2, for example, superconducting wire 10 has a non-coil shape. Other examples of superconducting wire 10 having the non-coil shape are illustrated in Figs. 4 to 6. In superconducting wire 10 in Figs. 2 and 4 to 6, superconducting wire 10 does not overlap in the radial direction of the curved portion of the superconducting wire. Accordingly, magnitude of the magnetic field generated by persistent current switch 8 can be reduced. Persistent current switch 8 is prevented from adversely affecting the main magnetic field generated from superconducting coil 3. Persistent current switch 8 enables highly accurate measurement by superconducting device 1. The restriction on the installation position of persistent current switch 8 in superconducting device 1 can be reduced.

As illustrated in Figs. 2 and 4 to 6, the held portion of superconducting wire 10 is held by holding member 30. Specifically, for example, the held portion of superconducting wire 10 is disposed in a groove (not illustrated) provided in holding member 30. Alternatively, for example, the held portion of superconducting wire 10 is embedded inside holding member 30. For example, holding member 30 is formed of a material having a low thermal conductivity. For example, holding member 30 is made of fiber reinforced plastic (FRP) such as glass fiber reinforced plastic (GFRP).

As illustrated in Fig. 2, heater 21 is provided only on a part of the held portion of superconducting wire 10. For example, the heater is provided over the length less than or equal to 50% of the length of the held portion of superconducting wire 10 in the longitudinal direction of superconducting wire 10. For example, the heater is provided over the length less than or equal to 40% of the length of the held portion of superconducting wire 10 in the longitudinal direction of superconducting wire 10. For example, the heater is provided over the length less than or equal to 30% of the length of the held portion of the superconducting wire 10 in the longitudinal direction of the superconducting wire 10. For example, the heater is provided over the length less than or equal to 20% of the length of the held portion of superconducting wire 10 in the longitudinal direction of superconducting wire 10.

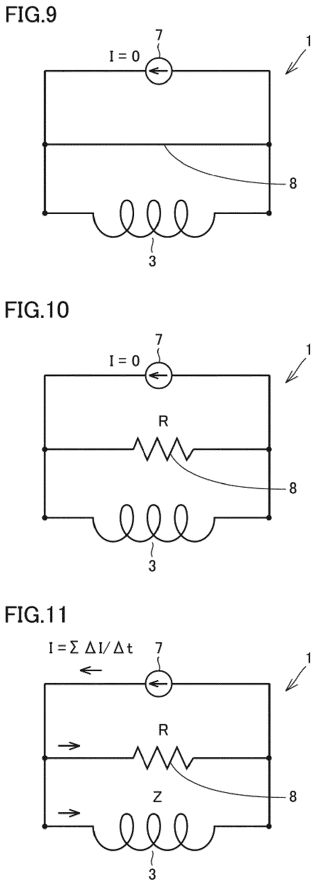

With reference to Figs. 9 to 14, the operation of persistent current switch 8 will be described. As illustrated in Figs. 1 and 9 to 14, persistent current switch 8 is connected in parallel to superconducting coil 3. Superconducting coil 3 and persistent current switch 8 are connected to a current source 7.

Superconducting coil 3 and persistent current switch 8 are cooled to a temperature lower than or equal to the superconducting transition temperature. Specifically, as illustrated in Fig. 1, superconducting coil 3 and persistent current switch 8 are immersed in liquid refrigerant 6. The current does not flow through heater 21, and heater 21 is in an off state. Superconducting layer 13 included in persistent current switch 8 transitions to the superconducting state. As illustrated in Fig. 9, persistent current switch 8 has zero electrical resistance. Persistent current switch 8 is turned on. Superconducting coil 3 also transitions to the superconducting state. A current I flowing from current source 7 is zero.

Then, the current is applied to heater 21 to turn on heater 21 (heat generation state). A part of superconducting wire 10 (superconducting layer 13) transitions to the normal conducting state. As illustrated in Fig. 10, the electric resistance of persistent current switch 8 is greater than zero, and persistent current switch 8 has an off-resistance R. Persistent current switch 8 is turned off. Current I flowing from current source 7 is still zero.

Then, as illustrated in Fig. 11, current I starts to flow from current source 7. Current I flowing from current source 7 is gradually increased from zero with a time change ΔI/Δt of current I. Superconducting coil 3 has inductance L. When current I flowing from current source 7 is gradually increased, coil impedance Z corresponding to time change ΔI/Δt of current I is generated in superconducting coil 3. An increased current from zero of current I flowing from current source 7 flows to persistent current switch 8 and superconducting coil 3 according to off-resistance R of persistent current switch 8 and coil impedance Z of superconducting coil 3. This increasing current is given by time integral ΣΔI/Δt of time change ΔI/Δt of current I.

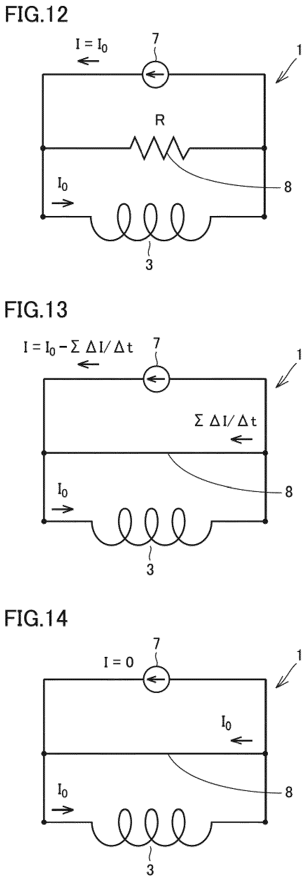

As illustrated in Fig. 12, when current I flowing from current source 7 reaches an operating current I₀ flowing to superconducting coil 3 in a persistent current mode, current I flowing from current source 7 is maintained at operating current I₀. Time change ΔI/Δt of current I flowing from current source 7 becomes zero, and coil impedance Z of superconducting coil 3 also becomes zero. On the other hand, persistent current switch 8 still has off-resistance R larger than zero. For this reason, the current flowing through persistent current switch 8 gradually decreases, and the current flowing through superconducting coil 3 gradually increases. Operating current I₀ flowing from current source 7 flows exclusively to superconducting coil 3. In this way, superconducting coil 3 is excited.

The flow of the current through heater 21 is stopped, and heater 21 is turned off. Liquid refrigerant 6 absorbs residual heat of heater 21. A part of superconducting wire 10 (superconducting layer 13) in the normal conducting state transitions to the superconducting state. As illustrated in Fig. 13, the electric resistance of persistent current switch 8 becomes zero. Persistent current switch 8 is turned on.

Then, as illustrated in Fig. 13, current I flowing from current source 7 is gradually decreased from operating current I₀ at time change -ΔI/Δt of current I. A decreasing current from operating current I₀ of current I flowing from current source 7 flows to persistent current switch 8. This decreasing current is given by time integral -ΣΔI/Δt of time change -ΔI/Δt of current I. As illustrated in Fig. 14, when the current flowing from current source 7 is set to zero, operating current I₀ circulates through persistent current switch 8 and superconducting coil 3. In this way, persistent current switch 8 can operate superconducting device 1 in the persistent current mode.

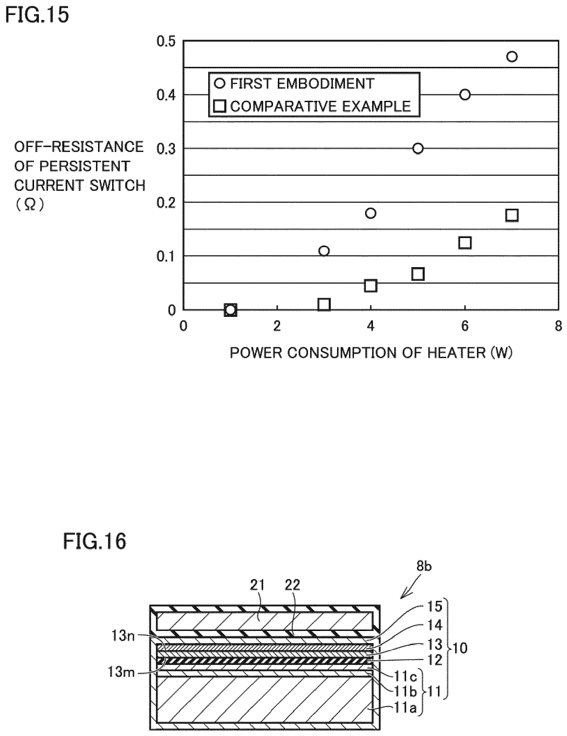

With reference to Fig. 15, action of persistent current switch 8 of the first embodiment will be described while being compared with a persistent current switch of a comparative example. The persistent current switch of the comparative example has the same configuration as persistent current switch 8 of the first embodiment, but is different in that heater 21 and insulating member 22 are disposed on the side of first principal surface 13m of superconducting layer 13. Specifically, in the comparative example, heater 21 and insulating member 22 are provided on a second surface of substrate 11 on the opposite side of a first surface of substrate 11 facing the first principal surface of superconducting layer 13. In the comparative example, insulating member 22 is disposed between the second surface of substrate 11 and heater 21.

It can be seen from Fig. 15 that persistent current switch 8 of the first embodiment operates with lower power consumption than the persistent current switch of the comparative example. The reason is as follows. In persistent current switch 8 of the first embodiment, heater 21 is disposed only on the side of second principal surface 13n of superconducting layer 13 with respect to superconducting layer 13. Accordingly, in the first embodiment, the heat dissipated to substrate 11 in the heat generated by heater 21 is reduced as compared with the comparative example. Superconducting layer 13 in persistent current switch 8 of the first embodiment can be more efficiently heated by heater 21 than superconducting layer 13 in the persistent current switch of the comparative example. Off-resistance R of persistent current switch 8 increases with less power consumption of heater 21.

In general, the larger off-resistance R of persistent current switch 8, the shorter the time required to operate superconducting device 1 in the persistent current mode. Accordingly, persistent current switch 8 of the first embodiment can operate superconducting device 1 in the persistent current mode in a shorter time than the persistent current switch of the comparative example.

Effects of persistent current switch 8 and superconducting device 1 of the first embodiment will be described.

Persistent current switch 8 includes superconducting wire 10, heater 21, and insulating member 22. Superconducting wire 10 includes substrate 11 and superconducting layer 13 provided on substrate 11. Superconducting layer 13 includes first principal surface 13m facing substrate 11 and second principal surface 13n on the opposite side of first principal surface 13m. Heater 21 is disposed only on the side of second principal surface 13n of superconducting layer 13 with respect to superconducting layer 13. Insulating member 22 is provided between second principal surface 13n of superconducting layer 13 and heater 21.

Heater 21 is disposed only on the side of second principal surface 13n of superconducting layer 13 with respect to superconducting layer 13. The heat dissipated to substrate 11 in the heat generated by heater 21 is reduced. Superconducting layer 13 can be efficiently heated by heater 21. In addition, because insulating member 22 is provided between second principal surface 13n of superconducting layer 13 and heater 21, insulating member 22 prevents the current flowing through heater 21 from flowing into superconducting layer 13. For this reason, the power consumption of heater 21 required for operating persistent current switch 8 is reduced. Persistent current switch 8 can operate at lower power consumption.

Superconducting device 1 includes persistent current switch 8, superconducting coil 3 connected to persistent current switch 8, and container 5 that accommodates persistent current switch 8 and superconducting coil 3. Accordingly, superconducting device 1 can operate with lower power consumption. Superconducting device 1 can operate in the persistent current mode in a shorter time.

### (Second Embodiment)

With reference to Fig. 16, a persistent current switch 8b will be described. Persistent current switch 8b of a second embodiment has the same configuration as persistent current switch 8 of the first embodiment, but is mainly different in the following points.

Superconducting wire 10 further includes a stabilization layer 15 having conductivity. For example, stabilization layer 15 is formed of a metal such as copper (Cu) or an alloy. Stabilization layer 15 is in contact with protective layer 14. For example, stabilization layer 15 has a larger thickness than protective layer 14. Protective layer 14 is provided between second principal surface 13n of superconducting layer 13 and stabilization layer 15. Stabilization layer 15 is provided between insulating member 22 and protective layer 14. Insulating member 22 is provided between stabilization layer 15 and heater 21. Heater 21 is separated from stabilization layer 15. Stabilization layer 15 covers an entire outer periphery of a laminated body including, for example, substrate 11, intermediate layer 12, superconducting layer 13, and protective layer 14. When the quenching (the phenomenon of transition from the superconducting state to the normal conducting state) occurs in superconducting layer 13, stabilization layer 15 bypasses the current flowing through superconducting layer 13 to prevent the burning of the superconducting wire 10.

As illustrated in Fig. 1, superconducting device 1 of the second embodiment includes persistent current switch 8b of the second embodiment instead of persistent current switch 8 of the first embodiment.

### (Third Embodiment)

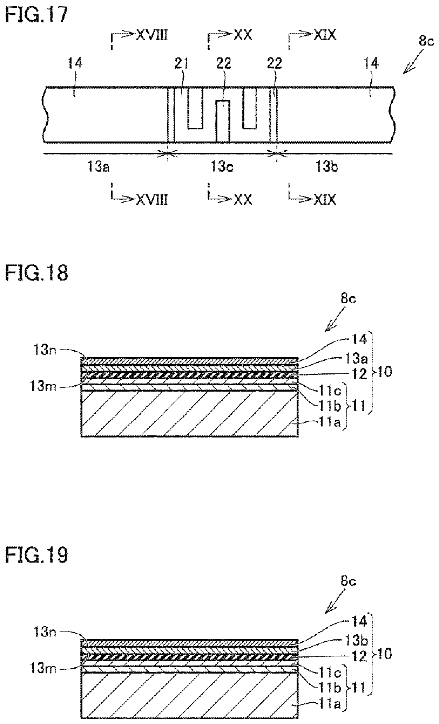

With reference to Figs. 17 to 20, a persistent current switch 8c will be described. Persistent current switch 8c of a third embodiment has the same configuration as persistent current switch 8 of the first embodiment, but is mainly different in the following points.

Superconducting layer 13 includes a first portion 13a, a second portion 13b, and a third portion 13c between the first portion 13a and the second portion 13b along the longitudinal direction of superconducting wire 10. Protective layer 14 is provided only on first portion 13a and second portion 13b. Protective layer 14 is not formed on third portion 13c, and third portion 13c of superconducting layer 13 is exposed from protective layer 14. Protective layer 14 formed on first portion 13a and protective layer 14 formed on second portion 13b are separated from each other in the longitudinal direction of superconducting wire 10 at third portion 13c.

Heater 21 is provided only on third portion 13c. Insulating member 22 is provided between heater 21 and third portion 13c. Heater 21 is not provided on first portion 13a and second portion 13b. Heater 21 is separated from protective layer 14 formed on first portion 13a and second portion 13b.

In a modification of the third embodiment, stabilization layer 15 is provided on protective layer 14 similarly to the second embodiment.

As illustrated in Fig. 1, superconducting device 1 of the third embodiment includes persistent current switch 8c of the third embodiment or a modification of the third embodiment instead of persistent current switch 8 of the first embodiment.

The third embodiment has the following effects in addition to the effects of the first embodiment.

Protective layer 14 is provided only on first portion 13a and second portion 13b, but is not provided on third portion 13c. For this reason, the current flowing through superconducting wire 10 cannot bypass third portion 13c. When third portion 13c is heated by heater 21 to be in the normal conducting state, all the current flowing through superconducting wire 10 flows through third portion 13c having high electric resistance. Even when the heating length or heating area of superconducting layer 13 using heater 21 is smaller, high off-resistance R of persistent current switch 8c can be obtained. The power consumption of heater 21 required for operating persistent current switch 8 c is reduced. Persistent current switch 8c may operate with less power consumption.

Heater 21 is provided only on third portion 13c exposed from protective layer 14, and is separated from protective layer 14. Accordingly, the current flowing through heater 21 is prevented from flowing into protective layer 14. The power consumption of the heater required for operating persistent current switch 8c is reduced. Persistent current switch 8c can operate with less power consumption of heater 21.

### (Fourth Embodiment)

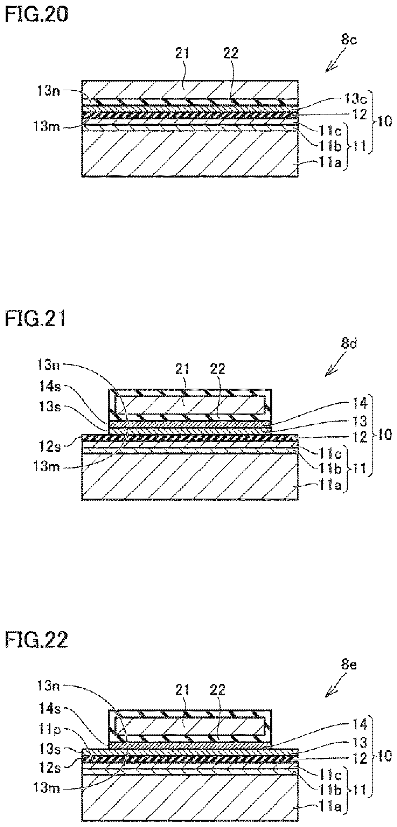

With reference to Fig. 21, a persistent current switch 8d will be described. Persistent current switch 8d of a fourth embodiment has the same configuration as persistent current switch 8 of the first embodiment, but is mainly different in the following points. In persistent current switch 8d, in plan view of second principal surface 13n of superconducting layer 13, a third side edge 13s of superconducting layer 13 and a first side edge 14s of protective layer 14 are located inside a second side edge 12s of intermediate layer 12.

When superconducting member 17 (see Figs. 7 and 8) is divided, sometimes the side edge of substrate 11 or first side edge 14s of protective layer 14 deforms and superconducting layer 13 or protective layer 14 comes into contact with substrate 11. In particular, when substrate 11 includes a layer (second layer 11b) made of relatively soft copper, and when superconducting member 17 is divided by a machine slit, there is a concern that superconducting layer 13 or protective layer 14 comes into contact with substrate 11. When superconducting layer 13 or protective layer 14 comes into contact with substrate 11, the heat generated by heater 21 is dissipated to substrate 11 to increase the power consumption of the persistent current switch.

On the other hand, in persistent current switch 8d, third side edge 13s of superconducting layer 13 and first side edge 14s of protective layer 14 are located inside second side edge 12s of intermediate layer 12. For this reason, even when substrate 11 or protective layer 14 deforms with respect to the machine slit of superconducting member 17, superconducting layer 13 and protective layer 14 are not in contact with substrate 11 and remain separated from substrate 11. The heat dissipation from heater 21 to substrate 11 through superconducting layer 13 or protective layer 14 can be reduced. Persistent current switch 8d can operate with lower power consumption.

Referring to Fig. 22, in a persistent current switch 8e of a first modification of the fourth embodiment, in superconducting wire 10, first side edge 14s of protective layer 14 is located inside second side edge 12s of intermediate layer 12 in plan view of second principal surface 13n of superconducting layer 13.

When superconducting member 17 (see Figs. 7 and 8) is divided, sometimes the side edge of substrate 11 or first side edge 14s of protective layer 14 deforms and protective layer 14 comes into contact with substrate 11. In particular, when substrate 11 includes the layer (second layer 11b) made of relatively soft copper, and superconducting member 17 is divided by the machine slit, there is a concern that protective layer 14 comes into contact with substrate 11. When protective layer 14 comes into contact with substrate 11, the heat generated by heater 21 is dissipated to substrate 11 to increase the power consumption of the persistent current switch.

On the other hand, in persistent current switch 8e, first side edge 14s of protective layer 14 is located inside second side edge 12s of intermediate layer 12. For this reason, even when substrate 11 or protective layer 14 deforms with respect to the machine slit of superconducting member 17, protective layer 14 is not in contact with substrate 11 and remains separated from substrate 11. The heat dissipation from heater 21 to substrate 11 through protective layer 14 can be reduced. Persistent current switch 8e can operate with lower power consumption.

In a second modification of the fourth embodiment, in superconducting wire 10 of the second embodiment or superconducting wire 10 of the third embodiment, like persistent current switch 8d of the fourth embodiment, third side edge 13s of superconducting layer 13 and first side edge 14s of protective layer 14 are located inside second side edge 12s of intermediate layer 12. In a third modification of the fourth embodiment, in superconducting wire 10 of the second embodiment or superconducting wire 10 of the third embodiment, like the persistent current switch 8e of the first modification of the fourth embodiment, first side edge 14s of protective layer 14 is located inside second side edge 12s of intermediate layer 12.

As illustrated in Fig. 1, superconducting device 1 of the fourth embodiment includes any one of persistent current switches 8d, 8e of the fourth embodiment and the first to third modifications of the fourth embodiment instead of persistent current switch 8 of the first embodiment.

### REFERENCE SIGNS LIST

1: superconducting device, 3: superconducting coil, 5: container, 6: liquid refrigerant, 7: current source, 8, 8b, 8c, 8d, 8e: persistent current switch, 10: superconducting wire, 11: substrate, 11a: first layer, 11b: second layer, 11c: third layer, 12: intermediate layer, 12s: second side edge, 13: superconducting layer, 13a: first portion, 13b: second portion, 13c: third portion, 13m: first principal surface, 13n: second principal surface, 13s: third side edge, 14: protective layer, 14s: first side edge, 15: stabilization layer, 17: superconducting member, 21: heater, 22: insulating member, 30: holding member

## Claims

1. A persistent current switch (8, 8b, 8c, 8d, 8e) comprising:
a superconducting wire (10);
a heater (21);
an insulating member (22), and
a holding member (30),
wherein the superconducting wire (10) includes a substrate (11) and a superconducting layer (13) provided on the substrate (11),
the superconducting layer (13) includes a first principal surface (13m) facing the substrate (11) and a second principal surface (13n) on an opposite side of the first principal surface (13m),
the heater (21) is disposed only on a side of the second principal surface (13n) with respect to the superconducting layer (13),
the insulating member (22) is provided between the second principal surface (13n) and the heater (21),
a held portion of the superconducting wire (10) is held by the holding member (30), **characterized in that**
the heater (21) is provided only on a part of the held portion.

2. The persistent current switch (8, 8b, 8c, 8d, 8e) according to claim 1, wherein the superconducting wire (10) further includes a protective layer (14) having conductivity,
the protective layer (14) is provided on the second principal surface (13n) of the superconducting layer (13) and is in contact with the superconducting layer (13), and
the insulating member (22) is provided between the protective layer (14) and the heater (21).

3. The persistent current switch (8, 8b, 8c, 8d, 8e) according to claim 2, wherein the protective layer (14) and the superconducting layer (13) are separated from the substrate (11).

4. The persistent current switch (8, 8b, 8c, 8d, 8e) according to claim 1, wherein the superconducting wire (10) further includes a protective layer (14) having conductivity,
the protective layer (14) is provided on the second principal surface (13n) of the superconducting layer (13) and is in contact with the superconducting layer (13),
the superconducting layer (13) includes a first portion (13a), a second portion (13b), and a third portion (13c) located between the first portion (13a) and the second portion (13b) along a longitudinal direction of the superconducting wire (10),
the protective layer (14) is provided only on the first portion (13a) and the second portion (13b),
the heater (21) is provided only on the third portion (13c) and is separated from the protective layer (14), and
the insulating member (22) is provided between the heater (21) and the third portion (13c).

5. The persistent current switch (8, 8b, 8c, 8d, 8e) according to any one of claims 2 to 4, wherein the superconducting wire (10) further includes a stabilization layer having conductivity,
the stabilization layer (15) is in contact with the protective layer (14),
the protective layer (14) is provided between the superconducting layer (13) and the stabilization layer (15), and
the heater (21) is separated from the stabilization layer (15).

6. The persistent current switch (8, 8b, 8c, 8d, 8e) according to any one of claims 1 to 5, wherein the superconducting wire further includes an intermediate layer (12) having an insulating
property, and
the intermediate layer (12) is provided between the substrate and the first principal surface

7. The persistent current switch (8, 8b, 8c, 8d, 8e) according to any one of claims 2 to 5, wherein the superconducting wire (10) further includes an intermediate layer (12) having an insulating property,
the intermediate layer (12) is provided between the substrate (11) and the first principal surface (13m), and
a first side edge (14s) of the protective layer (14) is located inside a second side edge (12s) of the intermediate layer (12) in plan view of the second principal surface (13n).

8. The persistent current switch (8, 8b, 8c, 8d, 8e) according to claim 7, wherein a third side edge (13s) of the superconducting layer (13) is located inside the second side edge (12s) of the intermediate layer (12) in plan view of the second principal surface (13n).

9. The persistent current switch (8, 8b, 8c, 8d, 8e) according to any one of claims 1 to 8, wherein the superconducting wire (10) has a non-coil shape.

10. The persistent current switch (8, 8b, 8c, 8d, 8e) according to claim 1, wherein the heater (21) is provided over a length less than or equal to 50% of a length of the held portion in a longitudinal direction of the superconducting wire (10).

11. The persistent current switch (8, 8b, 8c, 8d, 8e) according to any one of claims 1 to 10, wherein the superconducting layer (13) is formed of RE₁Ba₂Cu₃O_{y}, where y is greater than or equal to 6.0 and less than or equal to 8.0, and RE represents a rare earth element.

12. A superconducting device (1) comprising:
the persistent current switch (8, 8b, 8c, 8d, 8e) according to any one of claims 1 to 11;
a superconducting coil (3) connected to the persistent current switch (8, 8b, 8c, 8d, 8e); and
a container (5) that accommodates the persistent current switch (8, 8b, 8c, 8d, 8e) and the superconducting coil (3).

## Patentansprüche

1. Dauerstromschalter (8, 8b, 8c, 8d, 8e), umfassend:
einen supraleitenden Draht (10);
eine Heizvorrichtung (21);
ein isolierendes Element (22), und
ein Halteelement (30),
wobei der supraleitende Draht (10) ein Substrat (11) und eine supraleitende Schicht (13), die auf dem Substrat (11) vorgesehen ist, aufweist,
die supraleitende Schicht (13) eine erste Hauptfläche (13m), die dem Substrat (11) zugewandt ist, und eine zweite Hauptfläche (13n) auf einer gegenüberliegenden Seite der ersten Hauptfläche (13m) aufweist,
die Heizvorrichtung (21) nur auf einer Seite der zweiten Hauptfläche (13n) in Bezug auf die supraleitende Schicht (13) angeordnet ist,
das isolierende Element (22) zwischen der zweiten Hauptfläche (13n) und dem Heizer (21) vorgesehen ist,
ein Halteabschnitt des supraleitenden Drahtes (10) durch das Halteelement (30) gehalten wird,
**dadurch gekennzeichnet, dass**
die Heizvorrichtung (21) nur auf einem Teil des Halteabschnitts vorgesehen ist.

2. Dauerstromschalter (8, 8b, 8c, 8d, 8e) gemäß Anspruch 1, wobei der supraleitende Draht (10) ferner eine Schutzschicht (14) mit Leitfähigkeit aufweist,
die Schutzschicht (14) auf der zweiten Hauptfläche (13n) der supraleitenden Schicht (13) ausgebildet ist und mit der supraleitenden Schicht (13) in Kontakt steht, und
das isolierende Element (22) zwischen der Schutzschicht (14) und der Heizvorrichtung (21) vorgesehen ist.

3. Dauerstromschalter (8, 8b, 8c, 8d, 8e) gemäß Anspruch 2, wobei die Schutzschicht (14) und die supraleitende Schicht (13) von dem Substrat (11) getrennt sind.

4. Dauerstromschalter (8, 8b, 8c, 8d, 8e) gemäß Anspruch 1, wobei der supraleitende Draht (10) ferner eine Schutzschicht (14) mit Leitfähigkeit aufweist,
die Schutzschicht (14) auf der zweiten Hauptfläche (13n) der supraleitenden Schicht (13) vorgesehen ist und in Kontakt mit der supraleitenden Schicht (13) steht,
die supraleitende Schicht (13) einen ersten Abschnitt (13a), einen zweiten Abschnitt (13b) und einen dritten Abschnitt (13c), der zwischen dem ersten Abschnitt (13a) und dem zweiten Abschnitt (13b) entlang einer Längsrichtung des supraleitenden Drahtes (10) angeordnet ist, aufweist,
die Schutzschicht (14) nur auf dem ersten Abschnitt (13a) und dem zweiten Abschnitt (13b) ausgebildet ist,
die Heizung (21) nur auf dem dritten Abschnitt (13c) ausgebildet und von der Schutzschicht (14) getrennt ist, und
das isolierende Element (22) zwischen der Heizvorrichtung (21) und dem dritten Abschnitt (13c) ausgebildet ist.

5. Dauerstromschalter (8, 8b, 8c, 8d, 8e) gemäß einem der Ansprüche 2 bis 4, wobei der supraleitende Draht (10) ferner eine Stabilisierungsschicht mit Leitfähigkeit aufweist,
die Stabilisierungsschicht (15) in Kontakt mit der Schutzschicht (14) steht,
die Schutzschicht (14) zwischen der supraleitenden Schicht (13) und der Stabilisierungsschicht (15) ausgebildet ist, und
die Heizvorrichtung (21) von der Stabilisierungsschicht (15) getrennt ist.

6. Dauerstromschalter (8, 8b, 8c, 8d, 8e) gemäß einem der Ansprüche 1 bis 5, wobei der supraleitende Draht ferner eine Zwischenschicht (12) mit einer isolierenden Eigenschaft aufweist, und
die Zwischenschicht (12) zwischen dem Substrat und der ersten Hauptfläche ausgebildet ist.

7. Dauerstromschalter (8, 8b, 8c, 8d, 8e) gemäß einem der Ansprüche 2 bis 5, wobei der supraleitende Draht (10) ferner eine Zwischenschicht (12) mit einer isolierenden Eigenschaft aufweist,
die Zwischenschicht (12) zwischen dem Substrat (11) und der ersten Hauptfläche (13m) ausgebildet ist, und
eine erste Seitenkante (14s) der Schutzschicht (14) innerhalb einer zweiten Seitenkante (12s) der Zwischenschicht (12) in Draufsicht auf die zweite Hauptfläche (13n) angeordnet ist.

8. Dauerstromschalter (8, 8b, 8c, 8d, 8e) gemäß Anspruch 7, wobei eine dritte Seitenkante (13s) der supraleitenden Schicht (13) innerhalb der zweiten Seitenkante (12s) der Zwischenschicht (12) in Draufsicht auf die zweite Hauptfläche (13n) angeordnet ist.

9. Dauerstromschalter (8, 8b, 8c, 8d, 8e) gemäß einem der Ansprüche 1 bis 8, wobei der supraleitende Draht (10) eine Nicht-Spulenform aufweist.

10. Dauerstromschalter (8, 8b, 8c, 8d, 8e) gemäß Anspruch 1, wobei die Heizvorrichtung (21) über eine Länge von weniger als oder gleich 50% einer Länge des Halteabschnitts in einer Längsrichtung des supraleitenden Drahtes (10) vorgesehen ist.

11. Dauerstromschalter (8, 8b, 8c, 8d, 8e) gemäß einem der Ansprüche 1 bis 10, wobei die supraleitende Schicht (13) aus RE₁Ba₂Cu₃O_{y} gebildet ist, wobei y größer als oder gleich 6,0 und kleiner als oder gleich 8,0 ist und RE ein Seltenerdelement darstellt.

12. Supraleitende Vorrichtung (1), umfassend:
den Dauerstromschalter (8, 8b, 8c, 8d, 8e) gemäß einem der Ansprüche 1 bis 11;
eine supraleitende Spule (3), die mit dem Dauerstromschalter (8, 8b, 8c, 8d, 8e) verbunden ist; und
einen Behälter (5), der den Dauerstromschalter (8, 8b, 8c, 8d, 8e) und die supraleitende Spule (3) aufnimmt.

## Revendications

1. Commutateur à courant persistant (8, 8b, 8c, 8d, 8e) comprenant :
un fil supraconducteur (10) ;
un dispositif de chauffage (21) ;
un élément isolant (22), et
un élément de maintien (30),
dans lequel le fil supraconducteur (10) inclut un substrat (11) et une couche supraconductrice (13) placée sur le substrat (11),
la couche supraconductrice (13) inclut une première surface principale (13m) orientée vers le substrat (11) et une deuxième surface principale (13n) sur un côté opposé à la première surface principale (13m),
le dispositif de chauffage (21) est disposé uniquement sur un côté de la deuxième surface principale (13n) par rapport à la couche supraconductrice (13),
l'élément isolant (22) est placé entre la deuxième surface principale (13n) et le dispositif de chauffage (21),
une partie du fil supraconducteur (10) est maintenue par l'élément de maintien (30),
**caractérisé en ce que** le dispositif de chauffage (21) n'est prévu que sur une partie de la partie maintenue.

2. Commutateur à courant persistant (8, 8b, 8c, 8d, 8e) selon la revendication 1, dans lequel le fil supraconducteur (10) inclut en outre une couche protectrice (14) ayant une conductivité,
la couche protectrice (14) est placée sur la deuxième surface principale (13n) de la couche supraconductrice (13) et est en contact avec la couche supraconductrice (13), et
l'élément isolant (22) est placé entre la couche protectrice (14) et le dispositif de chauffage (21).

3. Commutateur à courant persistant (8, 8b, 8c, 8d, 8e) selon la revendication 2, dans lequel la couche protectrice (14) et la couche supraconductrice (13) sont séparées du substrat (11).

4. Commutateur à courant persistant (8, 8b, 8c, 8d, 8e) selon la revendication 1, dans lequel le fil supraconducteur (10) inclut en outre une couche protectrice (14) ayant une conductivité,
la couche protectrice (14) est placée sur la deuxième surface principale (13n) de la couche supraconductrice (13) et est en contact avec la couche supraconductrice (13),
la couche supraconductrice (13) inclut une première partie (13a), une deuxième partie (13b) et une troisième partie (13c) située entre la première partie (13a) et la deuxième partie (13b) le long d'une direction longitudinale du fil supraconducteur (10),
la couche protectrice (14) n'est appliquée que sur la première partie (13a) et la deuxième partie (13b),
le dispositif de chauffage (21) est placé uniquement sur la troisième partie (13c) et est séparé de la couche protectrice (14), et
l'élément isolant (22) est placé entre le dispositif de chauffage (21) et la troisième partie (13c).

5. Commutateur à courant persistant (8, 8b, 8c, 8d, 8e) selon l'une quelconque des revendications 2 à 4, dans lequel le fil supraconducteur (10) inclut en outre une couche de stabilisation ayant une conductivité,
la couche de stabilisation (15) est en contact avec la couche protectrice (14),
la couche protectrice (14) est placée entre la couche supraconductrice (13) et la couche de stabilisation (15), et
le dispositif de chauffage (21) est séparé de la couche de stabilisation (15).

6. Commutateur à courant persistant (8, 8b, 8c, 8d, 8e) selon l'une quelconque des revendications 1 à 5, dans lequel le fil supraconducteur inclut en outre une couche intermédiaire (12) ayant une propriété isolante, et
la couche intermédiaire (12) est placée entre le substrat et la première surface principale.

7. Commutateur à courant persistant (8, 8b, 8c, 8d, 8e) selon l'une quelconque des revendications 2 à 5, dans lequel le fil supraconducteur (10) inclut en outre une couche intermédiaire (12) ayant une propriété isolante,
la couche intermédiaire (12) est placée entre le substrat (11) et la première surface principale (13m), et
un premier bord latéral (14s) de la couche protectrice (14) est situé à l'intérieur d'un deuxième bord latéral (12s) de la couche intermédiaire (12) en vue en plan de la deuxième surface principale (13n).

8. Commutateur à courant persistant (8, 8b, 8c, 8d, 8e) selon la revendication 7, dans lequel un troisième bord latéral (13s) de la couche supraconductrice (13) est situé à l'intérieur du deuxième bord latéral (12s) de la couche intermédiaire (12) en vue en plan de la deuxième surface principale (13n).

9. Commutateur à courant persistant (8, 8b, 8c, 8d, 8e) selon l'une quelconque des revendications 1 à 8, dans lequel le fil supraconducteur (10) n'a pas la forme d'une bobine.

10. Commutateur à courant persistant (8, 8b, 8c, 8d, 8e) selon la revendication 1, dans lequel le dispositif de chauffage (21) est prévu sur une longueur inférieure ou égale à 50% d'une longueur de la partie maintenue dans une direction longitudinale du fil supraconducteur (10).

11. Commutateur à courant persistant (8, 8b, 8c, 8d, 8e) selon l'une quelconque des revendications 1 à 10, dans lequel la couche supraconductrice (13) est formée de RE₁Ba₂Cu₃O_{y}, où y est supérieur ou égal à 6,0 et inférieur ou égal à 8,0, et RE représente une terre rare.

12. Dispositif supraconducteur (1) comprenant :
le commutateur à courant persistant (8, 8b, 8c, 8d, 8e) selon l'une quelconque des revendications 1 à 11 ;
une bobine supraconductrice (3) connectée au commutateur à courant persistant (8, 8b, 8c, 8d, 8e) ; et
un conteneur (5) qui contient le commutateur à courant persistant (8, 8b, 8c, 8d, 8e) et la bobine supraconductrice (3).
